# EUROPEAN PATENT APPLICATION

(11) **EP 4 632 786 A1**
(43) Date of publication of application: **15.10.2025**
(21) Application number: 24169352.2
(22) Date of filing: 10.04.2024
(51) Int. Cl.: H01J 37/22, H01J 37/244, H01J 37/26, H01J 37/28

(54) **METHOD FOR OBTAINING A TILT SERIES OF IMAGES OF A SAMPLE AT A PLURALITY OF TILT ANGLES**

(71) Applicant: FEI COMPANY, Hillsboro, OR 97124 (US)
(72) Inventor: JANSSEN, Bart, Lent (NL); VARSLOT, Trond, Vuku (NO); FABER, Pybe, Eindhoven (NL); FRANKEN, Erik, Nuenen (NL)
(74) Representative: Janssen, Francis-Paul

(57) **Abstract**

A method and charged particle microscope for obtaining a tilt series of images based on exposure of a region of interest of a sample to a charged particle beam at a plurality of tilt angles. The method comprises the step of changing the tilt angle at a tilt angle speed while acquiring the tilt series of images. The method further comprises the step of tracking a position of at least a part of the sample during the changing of the tilt angle, and changing, based on the step of tracking the position, the relative position of the sample with respect to the charged particle beam to keep the region of interest within a field of view. As defined herein, the method comprises the steps of starting a recovery process based on a detection of an anomaly in the tracking of the position of the sample.

## Description

The present invention relates to a method and a charged particle microscope for obtaining a tilt series of images based on exposure of a region of interest (ROI) of a sample to a charged particle beam (CPB) at a plurality of tilt angles. More specifically, it pertains to a system that utilizes a charged particle optical column, a sample holder, a charged particle detector, and an imaging system to generate detailed images of samples for acquiring said tilt series of images.

In various scientific and industrial applications, it is often necessary to examine the microscopic structure and composition of samples. Traditional optical microscopes have limitations in resolution and are unable to provide sufficient detail for certain types of samples. To overcome these limitations, charged particle microscopes have been developed.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as a so-called "dual-beam" apparatus (e.g. a FIB-SEM) that additionally employs a Focused Ion Beam (FIB), allowing supportive activities such as ion-beam milling or lon-Beam-Induced Deposition (IBID). The skilled person will be familiar with the different species of charged particle microscopy.

These charged particle microscopes generally comprise several components, which will be explained below.

Firstly, a charged particle microscope comprises a charged particle optical column that is employed to direct a charged particle beam onto the sample. This optical column is responsible for directing and controlling the charged particles to the sample to ensure accurate imaging.

Additionally, the charged particle microscope comprises a sample holder for securely holding a sample in place during the imaging process. The sample holder is generally designed to accommodate various sample sizes and shapes, providing stability and reproducibility in positioning.

Furthermore, the charged particle microscope comprises a charged particle detector to capture charged particles that interact with the sample. The charged particle detector converts the energy or intensity of the charged particles into electrical signals, which can be further processed for image generation.

The charged particle microscope also includes an imaging system that is arranged for processing signals from the charged particle detector. The imaging system receives data from the charged particle detector and generates an image signal based on the collected information.

Transmission electron microscopes (TEMs) can be used to obtain high resolution images that reveal important details of many kinds of samples, including biological samples. In electron beam tomography, multiple images of a sample are needed for image reconstruction.

Typically, in tomography, tracking the field-of-view (FOV) is a time-consuming process. There are two main methods of tracking: 'tracking after', where images that have already been captured are used, and 'tracking before', where images are captured at a nearby area before the main acquisition. However, both these methods have their drawbacks. 'Tracking after' can fail when the imaging dose is low, leading to low signal-to-noise ratio (SNR). 'Tracking before' is more reliable but adds significant time to the process.

In a specific method of tomography called fast-incremental single-exposure (FISE) acquisition, the camera is always on, and there's no chance for tracking at all. This method assumes that the area of interest will remain in the FOV, which can be difficult or even impossible in certain situations. This FISE acquisition method is described in further detail in "Rapid tilt-series acquisition for electron cryotomography. Journal of Structural Biology. 2019 Feb 1;205(2):163-169.

It is an object of the disclosure to provide an improved method, in particular a method that improves the tracking of the field of view in tilt series acquisitions.

To this end, the disclosure provides a method as described in claim 1. The method as defined herein comprises the step of obtaining a tilt series of images based on exposure of a region of interest of a sample to a charged particle beam at a plurality of tilt angles. Additionally, the method includes changing the tilt angle at a tilt angle speed while acquiring the tilt series of images, as well as the step of tracking a position of at least a part of the sample during the changing of the tilt angle. Further, the method comprises the step of changing, based on the step of tracking the position, the relative position of the sample with respect to the charged particle beam to keep the region of interest within a field of view.

As defined herein, the method further comprises the step of starting a recovery process based on a detection of an anomaly in the tracking of the position of the sample.

The step of tracking the position is performed during the acquisition process of acquiring the tilt series, and thus the tracking allows the changing of the position based on the tracking of the position to correct for any changes, such as shifts, that might occur during the acquisition process. The tracking region thus allows for a continuous (or semi-continuous) way of tracking the position of the sample during the acquisition of the tilt series images. As defined herein, the tracking of the position may be monitored so that upon a detection of an anomaly in the tracking of the position of the sample, a recovery process may be started and performed. This allows tracking of the position of the sample to take place during the actual image acquisition process, with reduced risk of acquiring undesired images as an encountered anomaly may be corrected. With this the chances of a successful acquisition of a tilt series of images are increased.

At least some images of the tilt series of images may be used in a step of producing a tomographic image of a sample volume related to the region of interest. Thus, the method as defined herein also increases the chance of a successful tomographic image.

With this, the object as defined herein is achieved.

Further advantageous embodiments will be described below.

In an embodiment, the method comprises the step of determining a tracking accuracy. The tracking accuracy may be based on changes in the tracking of the position of at least a part of the sample during the changing of the tilt angle. The tracking accuracy may be based on a comparison of subsequent images, as will be explained in more detail later. In any event, an image can be used for determining a tracking accuracy. Tracking accuracy may include, for example, the position of the region of interest is within the image. Tracking accuracy may include, additionally or alternatively, a change in the position of the region of interest within subsequent images. Tracking accuracy may contain, in an embodiment, a `goodness of match'. This may, for example be used when searching for a feature in an image. This may additionally or alternatively be used when multiple matches exist with similar `goodness of fit'. In this latter case a comparison with the last known position of the feature may also be used to decide which is the correct match.

In an embodiment, the method comprises the step of starting the recovery process based on the tracking accuracy being outside of a target range. This may include starting the recovery process in case the position of the region of interest changes, in particularly whilst exceeding a certain threshold value, within subsequent images.

As indicated above, the method may comprise the step of using an image of the sample for detecting the anomaly. In other words, the detection of the anomaly can be based on analysis of an image of the sample. Although image-based feedback may be done in tilt tomography, it is particularly beneficial in continuous tilt tomography (CTT) as it can be used to ensure that an area of interest (such as the region of interest) does not move out of the field of view of the camera. This image-based feedback may also be referred to as image-based runout correction.

The method may comprise the step of interpreting an image stream that is captured during the acquisition of the tilt series images. The method may comprise the step of comparing subsequent images, for example coming from the image stream. From the comparison, an anomaly can be detected and subsequently the recovery process can be started.

The method may comprise the step of tracking the position of the sample based on sensor information. The sensor information may relate to the sample holder (i.e. sample stage). For example a movement sensor may be mounted close to the sample or close to the sample holder and may be arranged for giving information on x,y,z, displacements or movements of the sample, which sensor information may then be used for tracking the position of the sample during tilt changes.

In an embodiment, the recovery process comprises one or more of the following steps:
- blanking of the charged particle beam;
- changing the tilt angle;
- changing the tilt angle speed.

The blanking of the charged particle beam may be used for preventing exposure to the sample, in particular to a region of interest, when an anomaly is detected. Thus as part of the recovery process, the blanking of the beam may preserve the sample at a region of interest, at least until the anomaly is resolved.

In an embodiment, the recovery process comprises the step of changing the part of the sample that is being tracked.

The recovery process may include changing the magnification setting of the charged particle microscope, so that a known feature can be found in a larger field of view can be found.

In an embodiment, the method comprises the step of tracking a part of the sample that is outside of the region of interest. This may be based on images that are acquired at a different part of the sample. The method may comprise exposing a tracking region that is substantially outside of the region of interest (ROI). This ensures that the tracking process does not interfere with the imaging of the ROI, leading to less damage for the ROI and more accurate tomographic image reconstruction. By using a tracking region outside of the region of interest, it is possible to track the field of view during the acquisition of the tilt series images, leading to faster acquisition times for the tilt series with improved accuracy in view of the tracking ability during the acquisition.

In an embodiment, this step of tracking a part of the sample outside of the region of interest may be part of the recovery process. This ensures that the region of interest is not exposed after an anomaly is detected, and thus ensures the quality of the sample at the region of interest is maintained.

In an embodiment, the method comprises the step of resuming obtaining the tilt series of images. The resuming of obtaining the tilt series of images can be seen as a concluding step of the recovery process.

In an embodiment, the method may comprise the step of continuously tracking the position of the sample during obtaining the tilt series. This may comprise exposing a tracking region of the sample. The continuous exposure allows for real-time tracking of the sample, enabling precise monitoring and a timely activation of the recovery process (i.e. with minimal delay) whenever an anomaly is detected.

In an embodiment, the method can be applied to both step-by-step tomography and continuous tilt tomography. This versatility allows for the method to be utilized in various imaging techniques, providing flexibility in experimental setups.

According to an aspect, a charged particle microscope as defined in claim 11 is provided.

The charged particle microscope as defined herein includes a charged particle optical column for directing a charged particle beam onto a sample, a sample holder for holding a sample, and a charged particle detector and an imaging system for generating an image signal based on information from the charged particle detector. Additionally, the charged particle microscope is arranged for obtaining a tilt series of images based on exposure of a region of interest (ROI) of a sample to the charged particle beam (CPB) at a plurality of tilt angles. Furthermore, the charged particle microscope is arranged for changing the tilt angle at a tilt angle speed while acquiring the tilt series of images. Additionally, the charged particle microscope is arranged for tracking a position of at least a part of the sample during the changing of the tilt angle. The charged particle microscope may be arranged for changing the relative position of the sample with respect to the charged particle beam to keep the region of interest (ROI) within a field of view (FOV).

The charged particle microscope may be arranged for, or be part of a system that is arranged for, producing a tomographic image of a sample volume (that may be related to a region of interest of the sample) based on at least some images of the obtained tilt series.

As defined herein, the charged particle microscope M is arranged for starting a recovery process based on a detection of an anomaly in the tracking of the position of the sample.

Advantages of the ability of starting a recovery process have been elucidated with respect to the method above.

In an embodiment, the charged particle microscope is arranged for performing any of the embodiments of the method as disclosed herein.

For providing real-time feedback to the microscope, the imaging system of the charged particle microscope may have a first charged particle detector output interface for outputting a first data stream of data related to said charged particle detector, as well as a second charged particle detector output interface for outputting a second data stream of data related to said charged particle detector. These two charged particle detector output interfaces can be used for providing real-time feedback (from one output interface) while maintaining high data quality and reliability (from the other output interface). By having two charged particle detector output interfaces that are arranged for providing different data steams compared to each other, the system allows to have two separate data streams that can be used for different purposes.

As an example, the first data stream may be designed to prioritize data quality and reliability, ensuring accurate and dependable data output. Thus, the first data stream can be optimized for a high image quality standard that allows for producing the tomographic image of the sample volume related to said region of interest based on at least some images of the obtained tilt series.

The second data stream may be designed to be optimized for low latency and/or fixed latency. This allows for images of the tracking region to be obtained and used for providing real-time feedback to the charged particle system. The real-time feedback can be used for providing a relative adjustment between the sample and the charged particle beam, for example by means of a stage movement and/or a deflection of the charged particle beam.

As defined herein, latency relates to the time difference between the moment a charged particle hits the charged particle detector (i.e. charged particle camera) and the moment the information from that charged particle is ready to be used by any device that is positioned downstream of the output interface. An example of such a device that is/can be positioned downstream of the output interface, is given by a data storage, a feedback processing device, a controller, etcetera. Latency can relate to the average time difference or the maximum time difference.

In an embodiment that is suitable for charged particle microscopy, the latency is in the order of half the readout integration time of the charged particle detector. If the charged particle detector, which can be a TEM camera, for example, runs at 500 fps, every pixel readout takes 2 ms. Low latency means that the time it takes for the data to come from the charged particle detector and be output through said second output interface (after which it can be used by a further processing device, for example) is in the order of the pixel readout too. This means that the low latency should be in the order of ms. Based on this example, the average latency can be about 1 ms, and the maximum latency can be about 2 ms. Higher latency, even though not optimal, can still give beneficial effects for providing real-time feedback.

As indicated above, the maximum low latency output can be related to the frame rate of the charged particle detector. For a frame rate of 500 fps, the maximum low latency is preferably in the order of 1/500 = 2 ms. For a lower frame rate (e.g. 250 fps) the maximum low latency can be 1/250 = 4 ms.

As indicated above, the average low latency output can be related to the frame rate of the charged particle detector. For a frame rate of 500 fps, the average low latency is preferably in the order of 0.5*1/500 = 1 ms. For a lower frame rate (e.g. 250 fps) the average low latency can be 0.5*1/250 = 2 ms.

This average and/or maximum latency can be used for providing real-time feedback to the charged particle microscope, with which the field of view can be accurately tracked during acquisition of the tilt series.

### Brief description of the drawings

For a more thorough understanding of the present disclosure, and advantages thereof, reference is now made to the following descriptions taken in conjunction with the accompanying drawings, in which:
Fig. 1 shows a longitudinal cross-sectional view of a charged particle microscope, in particular a transmission charged particle microscope;
Fig. 2 shows an embodiment of a charged particle microscope as defined herein;
Fig. 3 shows a further embodiment of a charged particle microscope as defined herein;
Fig. 4 shows a further embodiment of a charged particle microscope as defined herein;
Fig. 5 shows a further embodiment of a charged particle microscope as defined herein;
Fig. 6a and 6b show a first embodiment of a tracking a region of interest of a sample for detecting an anomaly;
Fig. 7a and 7b show a second embodiment of a tracking a region of interest of a sample for detecting an anomaly;
Fig. 8a and 8b show a second embodiment of a tracking a region of interest of a sample for detecting an anomaly;
Fig. 9 shows an embodiment of using a tracking region that is outside of the region of interest.

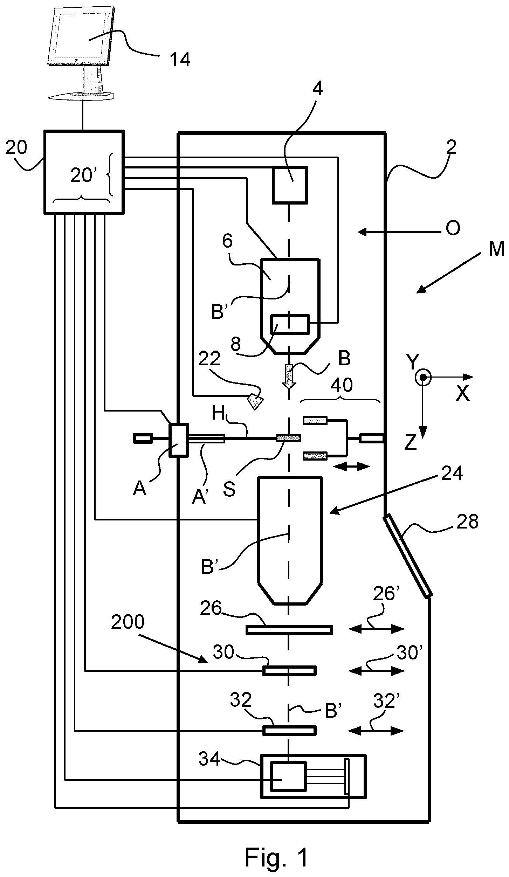

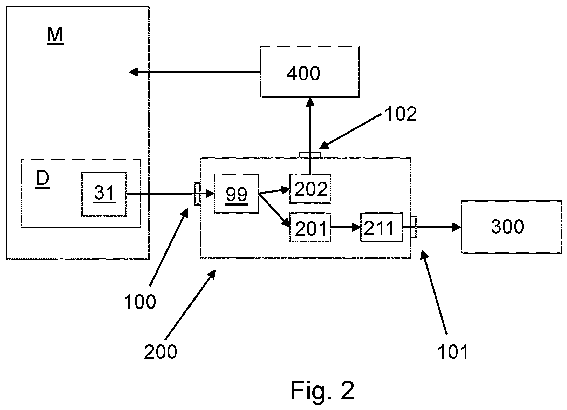

Fig. 1 (not to scale) is a highly schematic depiction of an embodiment of a charged-particle microscope M according to an embodiment of the invention. More specifically, it shows an embodiment of a transmission-type microscope M, which, in this case, is a TEM/STEM (though, in the context of the current invention, it could just as validly be a SEM (see Figure 2), or an ion-based microscope, for example). In Fig. 1, within a vacuum enclosure 2, an electron source 4 produces a beam B of electrons that propagates along an electron-optical axis B' and traverses an electron-optical illuminator 6, serving to direct/focus the electrons onto a chosen part of a sample S (which may, for example, be (locally) thinned/planarized). Also depicted is a deflector 8, which (*inter alia*) can be used to effect scanning motion of the beam B.

The sample S is held on a sample holder H that can be positioned in multiple degrees of freedom by a positioning device / stage A, which moves a cradle A' into which holder H is (removably) affixed; for example, the sample holder H may comprise a finger that can be moved (*inter alia*) in the XY plane (see the depicted Cartesian coordinate system; typically, motion parallel to Z and tilt about X/Y will also be possible). Such movement allows different parts of the sample S to be illuminated / imaged / inspected by the electron beam B traveling along axis B' (in the Z direction) (and/or allows scanning motion to be performed, as an alternative to beam scanning). If desired, an optional cooling device (not depicted) can be brought into intimate thermal contact with the sample holder H, so as to maintain it (and the sample S thereupon) at cryogenic temperatures, for example.

The electron beam B will interact with the sample S in such a manner as to cause various types of "stimulated" radiation to emanate from the sample S, including (for example) secondary electrons, backscattered electrons, X-rays and optical radiation (cathodoluminescence). If desired, one or more of these radiation types can be detected with the aid of analysis device 22, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the sample S, exit/emanate from it and continue to propagate (substantially, though generally with some deflection/scattering) along axis B'. Such a transmitted electron flux enters a projection system (projection lens 24), which will generally comprise a variety of electrostatic / magnetic lenses, deflectors, correctors (such as stigmators), *etc.* In normal (non-scanning) TEM mode, this projection system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of ) the sample S will be formed by projection system 24 on screen 26, and this may be viewed through viewing port 28 located in a suitable part of a wall of enclosure 2. The retraction mechanism for screen 26 may, for example, be mechanical and/or electrical in nature, and is not depicted here.

As an alternative to viewing an image on screen 26, one can instead make use of the fact that the depth of focus of the electron flux leaving projection system 24 is generally quite large (e.g. of the order of 1 meter). Consequently, various other types of analysis apparatus can be used downstream of screen 26, such as:
- TEM detector (camera) 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.
- STEM detector (camera) 32. An output from camera 32 can be recorded as a function of (X,Y) scanning position of the beam B on the sample S, and an image can be constructed that is a "map" of output from camera 32 as a function of X,Y. Camera 32 can comprise a single pixel with a diameter of e.g. 20 mm, as opposed to the matrix of pixels characteristically present in camera 30. Moreover, camera 32 will generally have a much higher acquisition rate (e.g. 10⁶ points per second) than camera 30 (e.g. 10² images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).
- As an alternative to imaging using cameras 30 or 32, one can also invoke spectroscopic detector 34, which could be an EELS module, for example.

It should be noted that the order/location of items 30, 32 and 34 is not strict, and many possible variations are conceivable. For example, spectroscopic detector 34 can also be integrated into the projection system 24.

In the embodiment shown, the microscope M further comprises a retractable X-ray Computed Tomography (CT) module, generally indicated by reference 40. In Computed Tomography (also referred to as tomographic imaging) the source and (diametrically opposed) detector are used to look through the sample along different lines of sight, so as to acquire penetrative observations of the sample from a variety of perspectives.

Note that the detectors 30,32, 34 are part of an imaging system (generally indicated with reference sign 200). The imaging system is arranged for generating an image signal based on information from the charged particle detector 30, 32, 34, and can be part of that detector or be a separate part from that detector. The controller (computer processor) 20 is connected to various illustrated components *via* control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired.

The skilled artisan will understand that the interior of the enclosure 2 does not have to be kept at a strict vacuum; for example, in a so-called "Environmental TEM/STEM", a background atmosphere of a given gas is deliberately introduced / maintained within the enclosure 2. The skilled artisan will also understand that, in practice, it may be advantageous to confine the volume of enclosure 2 so that, where possible, it essentially hugs the axis B', taking the form of a small tube (*e.g.* of the order of 1 cm in diameter) through which the employed electron beam passes, but widening out to accommodate structures such as the source 4, sample holder H, screen 26, camera 30, camera 32, spectroscopic detector 34, *etc.*

Thus, the charged particle microscope M shown in Fig. 1 comprises a charged particle optical column O for directing a charged particle beam B onto a sample; a sample holder H for holding a sample S; and a charged particle detector 22a, 22b, 30, 32, 34 with an imaging system 200 for generating an image signal based on information from the charged particle detector.

Now turning to Fig. 2, an embodiment of the charged particle microscope M including more details of the charged particle detector D and imaging system 200 as disclosed herein are shown. It is noted that generally, the detector D can be any one of TEM camera 30, STEM camera 32, spectroscopic detector 34 or segmented detector 22 as shown in Fig. 1, or any other charged particle detector in general, as long as the detector is suitable to be used in acquiring a tilt series of images.

Similar to Fig. 1, the charged particle microscope M comprises a detector D, which includes a detector chip 31. Raw data coming from that detector chip 31 is sent to an input interface 100 of imaging system 200. The imaging system 200 is arranged to generate an image signal based on information from the charged particle detector D.

As shown in Fig. 2, said imaging system 200 generally comprises an input interface 100 for receiving data, and a first charged particle detector output interface 101 for outputting a first data stream of data related to said charged particle detector D, as well as a second charged particle detector output interface 102 for outputting a second data stream of data related to said charged particle detector D.

In Fig. 2, the first charged particle detector output interface 101 is arranged for transferring data to storage 300. The connection from detector D, via imaging system 200, to storage 300 is used for storing high quality images from the sample. Here, the set-up of the first data stream is such that data quality and reliability are prioritized, ensuring accurate and dependable data output to storage 300 (i.e. maintaining the high image quality standard that present day charged particle microscopes are known for).

The imaging system also comprises a second charged particle detector output interface 102. The second charged particle detector output interface 102 is arranged for providing a different output compared to the first output interface 101. In particular, the second charged particle detector output interface 102 is arranged for providing low latency output to feedback data processing device 400, which in turn is connected to microscope M. Hence, a feedback control loop is established which can be used for feedback control applications, such as active image-based drift compensation, continuous tilt tomography field-of-view correction, or system state measurement methods.

Imaging system 200 comprises, in the embodiment shown, a data processing unit 99 that is arranged for processing so called "raw" data coming from detector chip 31. It is noted that this processing unit 99 may be part of the detector D itself, and thus the imaging system 200 may comprise a part of the detector D too. Other arrangements are conceivable as well.

After the initial processing that is done by processing unit 99, the signal may be split into two different streams.

One stream is connected to the first charged particle detector output interface 101, and includes a storage representation module 201 and a buffer 211. The storage representation module 201 and the buffer 211 are arranged for providing high quality image data from the detector D to the storage 300, substantially without loss of any image information.

One other stream is connected to the second charged particle detector output interface 102 and includes low latency representation module 202. The low latency representation module 202 is arranged to process the signal coming from the detector D (and optionally processed by data processing unit 99), and provide them to second charged particle detector output interface 102. From there, they can be forwarded to feedback data processing device 400, where additional processing for enabling real-time feedback to charged particle microscope M may take place. This enables low-latency feedback to be provided to charged particle microscope M, which may include stage moves and/or optics changes.

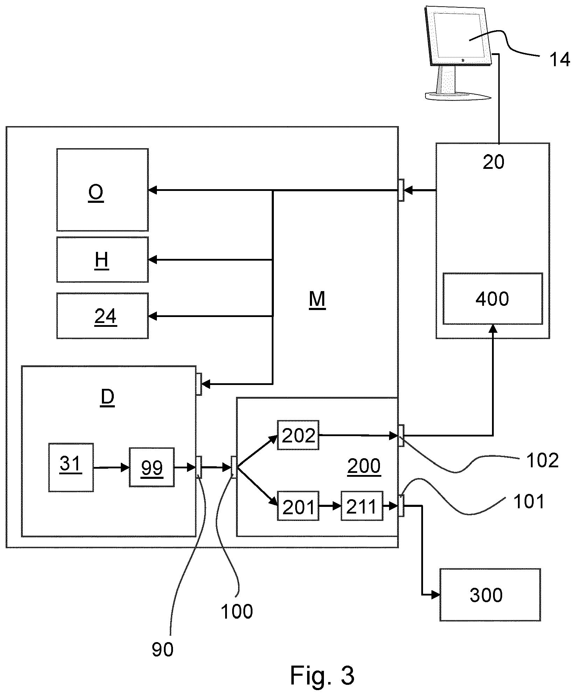

Fig. 3 shows a further embodiment of the charged particle microscope M with the imaging system 200 as disclosed herein. Here, the detector D comprises a camera chip 31 and a data processing unit 99. The data processing unit 99 is arranged for performing fast "essential" processing, which may include gain corrections and electron counting in case where the detector D is an electron detector. That processing will normally be done with a low latency. The resulting information is sent from detector D, through output 90 towards input interface 100 of imaging system 200. In imaging system 200, the data is split into two different representation blocks 201, 202. These 201, 202 may be arranged for converting the data into desired output-specific representation. These blocks 201, 202 may contain additional processing steps as well as data augmentation steps based on other information sources such as system clocks. For example, if the user chooses dose fraction storage, the storage representation block 201 will create dose fraction images, while the low-latency representation block 202 could output an Electron Event Representation stream (streams of electron event positions (x,y,time)), while embedding extra timing information such as synchronized time stamps. The storage representation 201 is buffered in block 211 to ensure no data is lost if e.g. the connection to the storage 300 gets shortly interrupted. The low-latency representation 202 is transmitted without buffering (or at least no large buffering) to prevent adding extra latency.

This low latency representation module 202 may, in an embodiment, run independently from the earlier mentioned storage representation module 201. The low latency representation module 202 is preferably optimized for low latency, while reliability of the data is a lower priority: this means that it is allowed to miss small portions of the data, as long as this is detectable.

A specific type of detector D of interest is an electron counting camera: in this case the electron counting algorithm is the key algorithm. The type of data on the output data interfaces 201 can be image "movies" (called dose fractions) or streams of electron event positions (x,y,time), which are also known as Electron Event Representation (EER). Providing EER data on the low latency output data interface 202 allows low latency event-based processing for low-dose applications. Under low-dose conditions, low-latency EER data will lead to the best possible performance in the use-cases mentioned above.

Turning back to Fig. 3, it is shown that the low latency representation module 202 may be connected to feedback data processing device 400, which, in the embodiment shown, is part of controller/processor 20. It will be clear to those skilled in the art that feedback data processing device 400 may be a separate controller/processor as well. From here, the controller/processor 20 is able to provide feedback to the charged particle microscopes M (as shown in Fig. 1 for example) by changing settings/parameters to one or more of the optical column O, the sample holder H, the imaging system 24 and/or charged particle detector D (which may be any one of 22a, 22b, 30, 32, 34 as shown in Fig. 1). Feedback data processing device 400, together with low latency representation module 202 thus allows real-time feedback to be supplied to the charged particle microscope M.

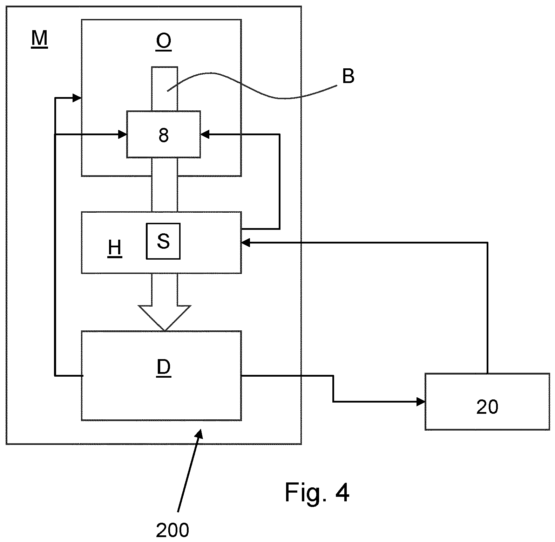

Fig. 4 shows a schematic view of an embodiment of the charged particle microscope M, including controller/processor 20, with which a tilt series of images as defined herein can be obtained. Like the embodiments of the charged particle microscopes as shown in Fig. 1-3, the charged particle microscope M shown in Fig. 4 comprises a charged particle optical column O for directing a charged particle beam B onto a sample S; a sample holder H for holding a sample S; and a charged particle detector D with an imaging system 200 for generating an image signal based on information from the charged particle detector. The charged particle microscope is arranged for obtaining a tilt series of images based on exposure of a region of interest (ROI) of a sample to said charged particle beam (CPB) at a plurality of tilt angles. The holder H is arranged for tilting the sample S for providing the plurality of tilt angles, as is known to those skilled in the art. The charged particle microscope M is arranged for tracking a position of the sample, as well as producing a tomographic image of a sample volume related to said region of interest based on at least some images of the obtained tilt series.

Detector D provides images to controller 20, which can then be used as feedback to the microscope M to modify the holder (position, angle, etcetera) to ensure that the region of interest is within the field of view. Detector D can be synchronized to the optical column D, and/or to a blanker/deflector 8 that is part of the optical column O. The low latency possibilities of the detector D and imaging system 200 as described herein aid in the feedback low that is shown in Fig. 4.

The embodiments of the charged particle microscope shown in Fig. 1 to 4 may be used in the method as described herein, which now will be further explained below.

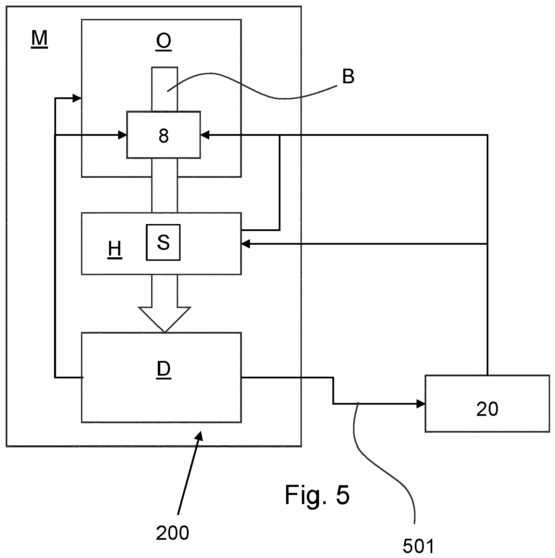

In a first embodiment, shown in Fig. 5, continuous tilt tomography using image-based runout correction is used. Here an image stream 501 coming from detector D during is interpreted using controller 20 in order to compute control values that are sent to the one or more of the sample holder H (i.e. movable sample stage) and the optical column O (i.e. optical elements thereof, such as beam deflector 8).

The image stream 501 interpretation may be done using a so-called tracker, which can be part of controller 20, although other systems (such as detector D) may comprise the tracker as well.

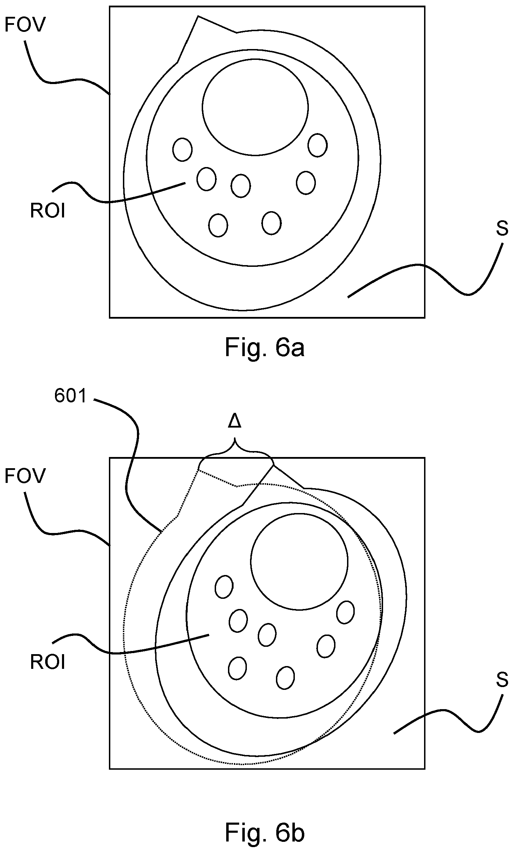

As shown in Fig. 6a and 6b, the tracker is arranged for comparing subsequent images. The comparing may be done to check for image shifts. Fig. 6a shows a first image of an illustrative sample S that is being examined in tomography. The sample S has a region of interest ROI, and is imaged within a field of view FOV. Fig. 6b shows a subsequent image of the illustrative sample of Fig. 6a. Here it can be seen that the outlines of the ROI have moved, as can be seen from the dashed line 601 which corresponds to the outline of the ROI in Fig. 6a. Here, the ROI has been rotated and shifted by an amount Δ. The tracker may be arranged for comparing the images and finding the image shift Δ. If the image shift Δ exceeds a certain threshold value, then the recovery process may be initiated.

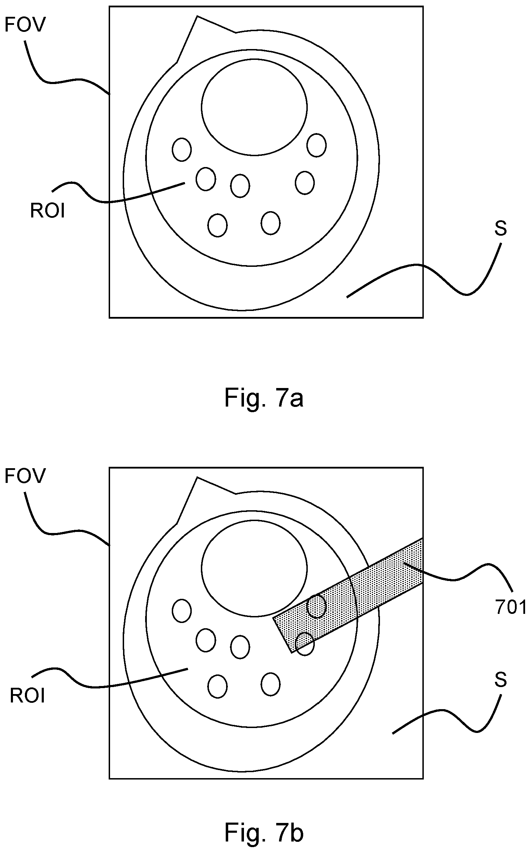

Fig. 7a and 7b show a different use-case of the tracker. Fig. 7a shows a first image of an illustrative sample S that is being examined in tomography. The sample S has a region of interest ROI, and is imaged within a field of view FOV. Fig. 7b shows a subsequent image of the illustrative sample of Fig. 7a. Here it can be seen that the outlines of the ROI have not moved, so no image shift has occurred. However, there is an anomaly 701 introduced in the image of Fig. 7b, which potentially endangers the acquisition of the image tilt series. The anomaly 701 can in principle be any disturbance that may occur during tomography, such as any contamination (ice growth in cryo-electron tomography) or unintended introduction of other foreign objects. The tracker may be arranged for detecting this anomaly, for example by tracking the average image value (grey values) between subsequent images).

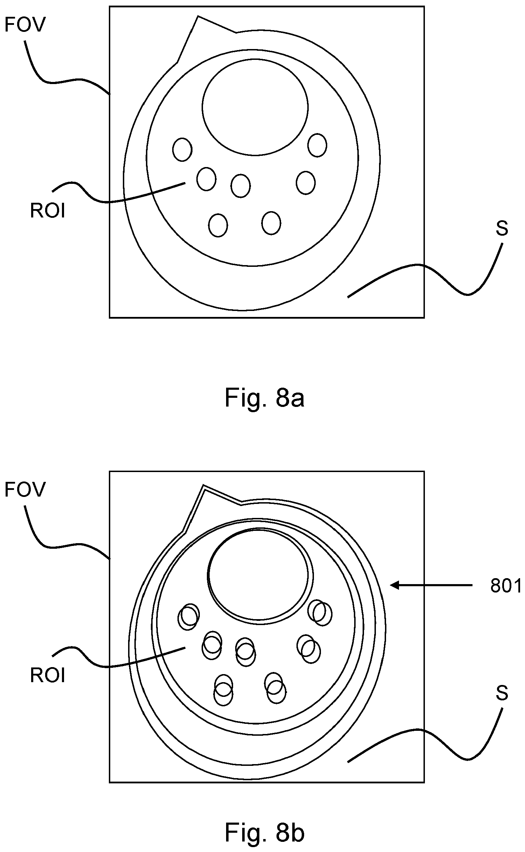

Fig. 8a and 8b show a further use-case of the tracker. Fig. 8a shows a first image of an illustrative sample S that is being examined in tomography. The sample S has a region of interest ROI, and is imaged within a field of view FOV. Fig. 8b shows a subsequent image of the illustrative sample of Fig. 8a. Here it can be seen that the outlines of the ROI have not moved (i.e. no image shift), and no foreign object is introduced either. However, the anomaly 801 in Fig. 8b concerns the focus of the sample S (which is indicated here, for reasons of simplicity, by the image having doubled outlines). Focus has changed and the region of interest ROI is clearly out of focus. The tracker may be arranged for detecting this anomaly 801, using edge detection, contrast transfer model fitting, or Thon ring localization for example. When (de)focus exceeds a certain threshold value, a recovery process may be initiated.

The recovery process may include, in an embodiment, a process of blanking the charged particle beam and stop the change of the tilt angle. Once the process of acquiring the tilt series is brought to a halt, a reinitialization may be performed, which may include returning to a last known good tilt angle, and restarting the tilt angle process including the tracking of the position.

In an embodiment, continuous tilt tomography can be performed with active drift-compensation.

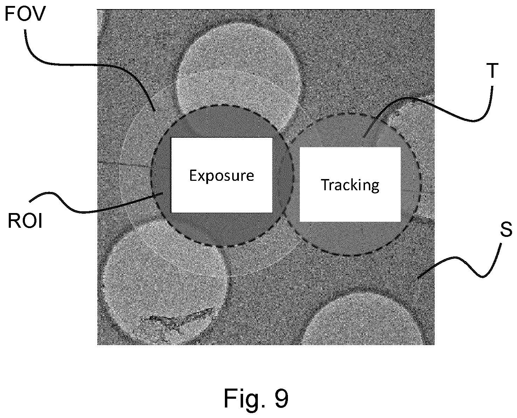

Fig. 9 shows an optional step that can be done. Here, the region of interest ROI is exposed for obtaining the images of the region of interest, and an area outside of the region of interest ROI is used for tracking purposes - the so-called tracking region T. The different regions ROI, T may be imaged intermittently using beam and image deflection, for example. It is possible that the sample holder H is continuously rotated, i.e. a continuous change in tilt angle is being performed. The tracked region T can be used for tracking the position of the sample S, as well as for detecting anomalies. When the tracker is (about to) lose track, the recovery process may be initiated.

The embodiment shown in Fig. 9 is especially useful in a low-dose regime, when radiation sensitive samples S are imaged, where a tracker could lose track. By using a tracking region T outside of the region of interest ROI it is possible to increase the tracking accuracy without actually damaging the region of interest ROI.

As used herein, "Image stream interpretation" could be any method that (indirectly) computes control values based on image data (either with or without combination with other sensor data).

The image stream interpretation may be done using the low-latency detection as described herein, but it is equally possible to use a lower acquisition speed to acquire the same results. In other words, the low-latency detection is not essential for performing the method as described herein.

The method and charged particle microscope M as described herein allow for tracking the position of the sample during tilt tomography, and allow for correction in case an anomaly is detected.

The technique can be used for Continuous Tilt Tomography (CTT).

## Claims

1. A method, comprising:
- obtaining a tilt series of images based on exposure of a region of interest (ROI) of a sample to a charged particle beam (CPB) at a plurality of tilt angles;
- changing the tilt angle at a tilt angle speed while acquiring the tilt series of images;
- tracking a position of at least a part of the sample during the changing of the tilt angle;
- changing, based on the step of tracking the position, the relative position of the sample with respect to the charged particle beam to keep the region of interest (ROI) within a field of view (FOV);
**Characterized in that** the method comprises the steps of starting a recovery process based on a detection of an anomaly in the tracking of the position of the sample.

2. Method according to claim 1, comprising the step of determining a tracking accuracy.

3. Method according to claim 2, wherein the recovery process is started based on the tracking accuracy being outside of a target range.

4. Method according to claims 1-3, wherein the detection of the anomaly is based on analysis of an image of the sample.

5. Method according to claim 1-4, wherein the tracking comprises the step of interpreting an image stream that is captured during the step of obtaining the tilt series of images.

6. Method according to claims 1-5, wherein the recovery process comprises one or more of the following steps:
- blanking of the charged particle beam;
- changing the tilt angle;
- changing the tilt angle speed;

7. Method according to claims 1-6, wherein the recovery process comprises the step of changing the part of the sample that is being tracked.

8. Method according to claims 1-5, wherein the method comprises the step of tracking a part of the sample outside of the region of interest.

9. Method according to claim 1-8, wherein the recovery process comprises the step of tracking a part of the sample outside of the region of interest.

10. Method according to claim 1-9, comprising the step of resuming obtaining the tilt series of images.

11. Charged particle microscope, comprising
- a charged particle optical column for directing a charged particle beam onto a sample;
- a sample holder for holding a sample; and
- a charged particle detector and an imaging system for generating an image signal based on information from the charged particle detector;
wherein the charged particle microscope is arranged for:
- obtaining a tilt series of images based on exposure of a region of interest (ROI) of a sample to the charged particle beam (CPB) at a plurality of tilt angles;
- changing the tilt angle at a tilt angle speed while acquiring the tilt series of images;
- tracking a position of at least a part of the sample during the changing of the tilt angle; and
- changing, based on the step of tracking the position, the relative position of the sample with respect to the charged particle beam to keep the region of interest (ROI) within a field of view (FOV);
**Characterized in that** the charged particle microscope is arranged for starting a recovery process based on a detection of an anomaly in the tracking of the position of the sample.
